Europäisches Patentamt

European Patent Office

Office européen des brevets

(11) Veröffentlichungsnummer: **0 227 908**

**A1**

(12) # EUROPÄISCHE PATENTANMELDUNG

(21) Anmeldenummer: **86114868.2**

(22) Anmeldetag: **27.10.86**

(51) Int. Cl.⁴: **G01R 19/00 , G01R 13/34**

(30) Priorität: **18.11.85 HU 437585**

(43) Veröffentlichungstag der Anmeldung:
**08.07.87 Patentblatt 87/28**

(84) Benannte Vertragsstaaten:
**DE FR GB IT**

(71) Anmelder: **MIKI Méréstechnikai Fejleszto Vállalat**
**Pethényi ut 5/7**
**H-1122 Budapest(HU)**

(72) Erfinder: **Balogh. András, Dipl.-Ing.**
**Bajvivo u 8**
**H-1027 Budapest(HU)**
Erfinder: **Bella, Lajos**
**Kuruclesi u 52**
**H-1021 Budapest(HU)**
Erfinder: **Somogyi, Gyula, Dipl.-Ing.**
**Toronyház u 16**
**H-1098 Budapest(HU)**

(74) Vertreter: **Altenburg, Udo, Dipl.-Phys. et al**
**Patent- und Rechtsanwälte**
**Bardehle-Pagenberg-Dost-Altenburg-Frohwi-**
**tter & Partner Postfach 86 06 20**
**D-8000 München 86(DE)**

(54) **Vorrichtung zur Spannungsmessung durch Abtastung.**

(57) Vorrichtung zur Spannungsmessung durch Abtastung, enthaltend eine von einem Steuergenerator - (12) angetriebene, die zu messende Spannung abtastende Einheit (2), einen das abgetastete Signal verstärkende Verstärker (3) und eine das verstärkte Signal der vorgeschriebenen Messaufgabe entsprechend auswertende Signalverarbeitungseinheit (6). Gemäß der Erfindung weist die Vorrichtung einen, ein Hilfssignal herstellenden Hilfsoszillator (14), sowie zwischen der Abtasteinheit (2) und der Signalverarbeitungseinheit (6) einen Verstärker (3) von steuerbarer Verstärkung und einen Differenzkreis (5) auf. Das Hilfssignal ist einerseits, mit der zu messenden Spannung zusammen, an einem Signaleingang - (17) der Abtasteinheit (2), andererseits durch einen Phasenschieber (13) an einen Eingang (25) des Differenzkreises (5) angeschlossen. Zwischen einerseits den Ausgang des Differenzkreises (5) und/oder seinen dem steuerbaren Verstärker (3) angeschlossenen anderen Eingang (24), andererseits den Steuereingang (21) des steuerbaren Verstärkers (3) ist ein auf die Frequenz des Hilfssignals selektiver Rückkopplungszweig (28) angeschlossen.

Fig.1

## Vorrichtung zur Spannungsmessung durch Abtastung

Der Gegenstand der Erfindung ist eine Vorrichtung zur Spannungsmessung durch Abtastung, welche besonders in, im breiten Frequenzbereich arbeitenden individuellen Geräten oder in Messautomaten verwendet werden kann.

Bei hochfrequenten Voltmetern bestimmt und dadurch auch beschränkt die gewählte Wirkungsweise im allgemeinen das Anwendungsgebiet des Messgerätes. Die Zahl der wählbaren Systeme ist im Falle der Anwendung in Messautomaten weiter verengt. Bei diesen Messgeräten mit einer oberen Grenzfrequenz von GHz Grössenordnung ist es nämlich notwendig eine schnelle Funktion, eine grosse Genauigkeit und gute zeitliche sowie thermische Stabilität zu gewährleisten.

Für die in Messautomaten auch anwendbaren und programmierbaren Hochfrequenzvoltmeter sind zwei Lösungstypen bekannt: ein mit einem Detektor und ein nach dem Grundsatz der inkohärenten (stochastischen)Abtastung arbeitender Typ. Mit diesen zwei Gerätarten kann theoretisch annähernd der gleiche Messfrequenzbereich erreicht werden.

Im Falle des Gerätes mit einem Detektor kommt das zu messende Hochfrequenzsignal auf den Eingang des aus Dioden aufgebauten Detektorkreises an. Das am Ausgang des Detektorkreises erscheinende Gleichspannungssignal ist infolge der Diodencharakteristiken bei kleinen Eingangspegeln mit dem wahren Effektivwert des Eingangssignals, bei grossen Eingangspegeln aber mit dem Scheitelwert des Eingangssignals proportional. Die Übertragungscharakteristik des Detektorkreises ist nichtlinear, ferner nimmt der Umsetz wirkungsgrad in der Richtung der kleinen Pegel schnell ab. Das Ausgangssignal des Detektorkreises kommt deshalb, nach entsprechender Verstärkung, zum Eingang eines nichtlinearen Verstärkers an. Der nichtlineare Verstärker kompensiert die Nichtlinearität des Detektorkreises mit Hilfe eines Brechpunktnäherungskreises. Das Ausgangssignal des nichtlinearen Verstärkers kann einem Messgerät, bzw. durch einen analog-digitalen Umwandler einer Digitalanzeige oder für Weiterbearbeitung einer Rechenmaschine zugeführt werden.

Bei diesem Messprinzip ergeben sich die folgenden Nachteile:
-die nichtlineare Übertragungscharakteristik des Detektors muss mit einem nichtlinearen Stromkreis von Brechpunktannäherung linearisiert werden, was aber eine schwierige, von den einzelnen Dioden abhängige Einstellung erfordert;
-im Falle von kleinen und grossen Eingangspegeln ist der Ausgangssignal. des Detektorkreises mit je anderem Parameter des Eingangssignals proportional (Effektivwert, Scheitelwert), deshalb ist die Messung bei Komplexsignalen (z.B. Geräusch) in Funktion des Pegels nicht eindeutig auswertbar;
-im Falle kleiner Eingangspegel nimmt der Umsetzwirkungsgrad des Detektors, infolge der Diodencharakteristiken, stürmisch ab, folgenderweise wird das Gerät unter einem Eingangspegel von etwa 200 μV unempfindlich, und als Ergebnis kann das Gerät binnen der kleinsten Messbereichgrenzen nicht genullt werden, es kann nur ein Nullbereich angegeben werden.

Die Funktion des nach dem Grundsatz der inkohärenten Abtastung arbeitenden Gerätes ist wie folgt. Das zu messende Hochfrequenzsignal kommt auf den Eingang eines Abtasters an. Der Abtaster schaltet das zu messende Signal, der Frequenz eines spannungsgesteuerten Oszillators entsprechend, für eine sehr kleine Weile an den Eingang eines Verstärkers von konstanter Verstärkung. Die Abtastung dauert z.B. einigen 100 psec lang, so ladet sich die Eingangskapazität des Verstärkers in dem ganzen Frequenzbereich des Geräts auf eine, mit dem im Moment der Abtastung aufgenommenen Momentanwert des zu messenden Signals proportionale Spannung auf, während sie sich zwischen zwei Abtastungen entladet. Die Amplitude der am Ausgang des Verstärkers erscheinenden Impulsreihe ist also im Zeitpunkt einer Abtastung dem Momentanwert des zu messenden Signals proportional. Wenn die Frequenz der Abtastung sich im Vergleich mit dem zu messenden Signal stochastisch verändert, d.h. die Abtastung inkohärent ist, und Abtastwerte aus dem zu messenden Signal in sehr grosser Anzahl entnommen werden können, stimmen die statistischen Kennwerte der abgetasteten Impulsreihe (Scheitel-, Mittel-und Effektivwert) mit den entsprechenden Werten des zu messenden Signals überein - (Grundsatz der stochastischen Abtastung). Die stochastische Abtastung geschieht so, dass die Frequenz des die Abtastung steuernden spannungsgesteuerten Oszillators von einem anderen Oszillator in der Frequenz moduliert ist.

Die nach dem Grundsatz der inkohärenten Abtastung arbeitende Vorrichtung weist, im Vergleich mit dem Detektortyp, die folgenden Vorteile auf:
-die Übertragungscharakteristik des Abtasters ist linear, weil der abgetastende Schalter von einem Signal von konstanter Amplitude gesteuert ist, folgenderweise hängt der Umsetzwirkungsgrad vom Pegel des zu messenden Signals nicht ab;
-das Ausgangssignal des Abtasters weist, unabhängig von den Eingangspegeln, die statistischen Parameter des zu messenden Signals auf, deshalb kann bei der Messung von komplexen Signalen (z.B. Geräusch) die Messung eindeutig ausgewertet werden;

-da die Öffnung des Reihenschalters des Abtasters von einem, von dem zu messenden Signal unabhängigen Signal durchgeführt ist, ist der Umsetzwirkungsgrad des Abtasters vom Pegel des zu messenden Signals unabhängig, so kann die Vorrichtung eindeutig nulliert werden.

Der Nachteil der, nach dem Grundsatz der inkohärenten Abtastung arbeitenden Vorrichtung besteht darin, dass der Umsetzwirkungsgrad des Abtasters in bedeutendem Maße von der Aussentemperatur abhängt, was als eine scheinbare Verstärkungsänderung erscheint. Dieser Wert ist annähernd das Drei-bzw. Vierfache des Wertes, der für die mit Diodendetektor arbeitenden Vorrichtungen charakteristisch ist. Dieses Problem ist in einer bekannten Lösung so beseitigt, dass in der Vorrichtung eine innere Eichungseinheit eingebaut ist, an deren Ausgang der Meßeingang angeschlossen werden kann, und dadurch die Vorrichtung an der jeweiligen Umgebungstemperatur geeicht werden kann. Diese Eichungseinheit ist eigentlich ein Etalon, sodass sie ziemlich teuer ist. Der Nachteil dieser Lösung ist ferner im Falle ihrer Verwendung in einem Meßautomat offensichtlich, da durch die zeitweiligen Unterbrechung des Meßvorganges die Dauer der Messung mit dem Meßautomat bedeutend verlängert wird.

Der Zweck der Erfindung ist, neben der Beibehaltung der Vorteile des nach dem Grundsatz der inkohärenten Abtastung arbeitenden Vorrichtung, die Schaffung einer Lösung, welche trotz den Veränderungen der temperaturabhängigen Parameter der verwendeten Bestandteile und Stromkreiseinheiten, eine temperaturunabhängige Messung ohne Unterbrechung des Meßvorganges sichert. Das gesetzte Ziel ist gemäß der Erfindung durch die Verwendung eines Hilfssignals erreicht, wobei das Hilfssignal, ohne den gemessenen Spannungswert zu verfälschen, die stabile Messung sichert.

Die Erfindung ist also eine Vorrichtung zur Spannungsmessung durch Abtastung, welche eine, die zu messende Spannung abtastende Einheit, einen das abgetastete Signal verstärkenden Verstärker und eine das verstärkte Signal der vorgeschriebenen Meßaufgabe entsprechend auswertende Signalverarbeitungseinheit aufweist, wobei die Abtasteinheit an einen Steuergenerator angeschlossen ist. Gemäß der Erfindung weist die Vorrichtung einen, ein Hilfssignal her stellenden Hilfsoszillator, sowie zwischen der Abtasteinheit und der Signalverarbeitungseinheit einen Verstärker von steuerbarer Verstärkung und einen Differenzkreis auf, wobei das Hilfssignal einerseits, mit der zu messenden Spannung zusammen, an einen Signaleingang der Abtasteinheit, andererseits durch einen Phasenschieber an einen Eingang des Differenzkreises angeschlossen ist, ferner zwischen einerseits den Ausgang des Differenzkreises und/oder seinen dem steuerbaren Verstärker angeschlossenen anderen Eingang, andererseits den Steuereingang des steuerbaren Verstärkers ein auf die Frequenz des Hilfssignals selektiver Rückkopplungszweig angeschlossen ist.

Gemäß der Erfindung ist das Hilfssignal zwischen der Abtasteinheit und dem Differenzkreis ständig auf das zu messende Spannungssignal überlagert, nach dem Differenzkreis weist es aber - schon so einen kleinen Wert auf, daß es die Spannungsmessung nicht beeinflußt. Der vor und/oder nach dem Differenzkreis angeschlossene, auf die Frequenz des Hilfssignals selektive Rückkopplungszweig kann -gegebenenfalls nebst entsprechender Verstärkung -das Hilfssignal fühlen, und aufgrund dessen, durch den steuerbaren Verstärker rücksteuern. Wenn der Rückkopplungszweig vor dem Differenzkreis angeschlossen ist, kann seine Verstärkung viel kleiner sein, weil das zu fühlende Hilfssignal hier größer ist. Die Lösung gemäß der Erfindung erfordert keinen hochstabilen Hilfsoszillator.

Der Rückkopplungszweig kann vorteilhaft so ausgestaltet werden, daß er sich an den Ausgang des Differenzkreises anschließt, und einen weiteren Verstärker, einen durch Ausgangssignal des Phasenschiebers gesteuerten phasenempfindlichen Gleichrichter und einen ersten Tiefpassfilter enthält, die in Reihe geschaltet sind.

Die Selektivität des Rückkopplungszweiges kann noch weiter erhöht werden, wenn der weitere Verstärker eine Tiefpasscharakteristik aufweist, z.B. vom Integriertyp ist.

Der Rückkopplungszweig ist in einer anderen möglichen Ausführung dem erwähnten anderen Eingang des Differenzkreises angeschlossen, und enthält einen phasenempfindlichen Gleichrichter, ein Gleichspannungsdifferenzglied, einen weiteren Verstärker und einen ersten Tiefpassfilter, wobei ein Eingang des Gleichspannungsdifferenzglieds durch Zwischenschaltung eines Gleichrichters an den Phasenschieber angeschlossen ist. Bei dieser Ausführung ist das, durch den Rückkopplungszweig gefühlte Hilfssignal größer, so ist das Signal -Rausch -Verhältnis besser.

In einer weiteren möglichen Ausführung ist der Rückkopplungszweig dem Ausgang und auch dem erwähnten anderen Eingang des Differenzkreises angeschlossen. In diesem Fall enthält der Rückkopplungszweig ein, sich mit seinen zwei Eingängen an den Ausgang und an den erwähnten anderen Eingang des Differenzkreises anschließendes erstes Differenzglied, ein zweites Differenzglied, einen weiteren Verstärker, einen phasenempfindlichen Gleichrichter und einen ersten Tiefpassfilter, die in Reihe geschaltet sind, wobei ein Eingang des zweiten Differenzglieds und der Steuereingang des phasenempfindlichen Gleichrichters an den Phasenschieber angeschlossen sind. Diese Ausgestaltung sichert ein gutes Signal-Rausch-Verhältnis, und ist mit dem Vorteil verbunden, daß der Differenzkreis sich in dem Regelkreis befindet.

In einer, zur Hochfrequenzspannungsmessung geeigneten Ausführung ist es vorteilhaft, wenn der erwähnte andere Eingang des Differenzkreises durch Zwischenschaltung eines, im Verhältnis zur Abtasteinheit verzögert gesteuerten Abtast-und Haltestromkreises an den Ausgang des steuerbaren Verstärkers angeschlossen ist. Es ist zweckmäßig, wenn -neben der Regelung mit dem gewählten Hilfssignal -der Ausgang des Abtast-und Haltestromkreises durch einen zweiten Tiefpassfilter an eine Rückkopplungseingang der Abtasteinheit angeschlossen ist. Diese zweite negative Rückkopplung sichert vorerst die Gleichspannungsstabilität der Abtasteinheit.

Die Lösung gemäß der Erfindung ist bei, mit inkohärenter Abtastung durchgeführter Messung stochastischen Charakters besonders geeignet. Dazu ist der, die Abtasteinheit steuernde Generator ein spannungsgesteuerter Oszillator, dessen Steuereingang an eine Spannungsquelle vom veränderlichen Ausgangssignal angeschlossen ist. Die Erfindung kann aber bei einer mit kohärenter oder Shannen'scher Abtastung durchgeführter Messung auch verwendet werden. In diesem Falle ist der, die Abtasteinheit steuernde Generater eine Einheit, die ein der jeweiligen Frequenz der zu messenden Spannung entsprechendes Signal, bzw. ein Signal von konstanter Spannung erzeugt.

Bei einer Ausführung von inkohärenter Abtastung ist es vorteilhaft, wenn die Frequenz des Hilfsoszillators kleiner als die untere Grenze des Frequenzbereichs der zu messenden Spannung ist. Dadurch kann die Meßgenauigkeit noch weiter gesteigert werden.

Eine zum Zwecke der Hochfrequenzspannungsmessung ausgestaltete Ausführung ist besonders vorteilhaft, wenn die Abtasteinheit einen analogen Diodenschaltstromkreis enthält, dessen Signaleingang einerseits durch einen Kondensator an den, die zu messende Spannung annehmenden Eingang, andererseits durch in Reihe geschaltete Widerstände und einen Durchführungskondensator an den Ausgang des Hilfsoszillators angeschlossen ist.

In der Vorrichtung gemäß der Erfindung soll die Signalverarbeitungseinheit der gewünschten Meßaufgabe entsprechend gewählt werden. Diese kann ein, den Effektivwert, den Scheitelwert oder den elektrolytischen Mittelwert messender Stromkreis, oder deren Kombination mit Umschaltungsmöglichkeit sein. Zur Durchführung komplizierterer Meßaufgaben, z.B. zur statistischen Analyse des zu messenden Spannungssignals, kann die Signalverarbeitungseinheit als eine analoge, oder nach einem analog-digitalen Umformer geschaltete digitale Verarbeitungseinheit ausgestaltet werden.

Die Erfindung wird im weiteren aufgrund der, in den Zeichnungen dargestellten Ausführungsformen eingehend beschrieben, wobei

Fig. 1 ein Blockschema der Vorrichtung gemäß der Erfindung ist,

Fig. 2 und 3 Blockschemen von je einer weiteren vorteilhaften Ausführung des Rückkopplungszweiges der Vorrichtung gemäß Fig. 1 darstellen, und

Fig. 4 ein detailliertes Schaltungsschema der Kopplungseinheit und der Abtasteinheit der Vorrichtung gemäß Fig. 1 darstellt.

In den Zeichnungen sind die gleichen Elementen mit den gleichen Bezeichnungsnummern bezeichnet.

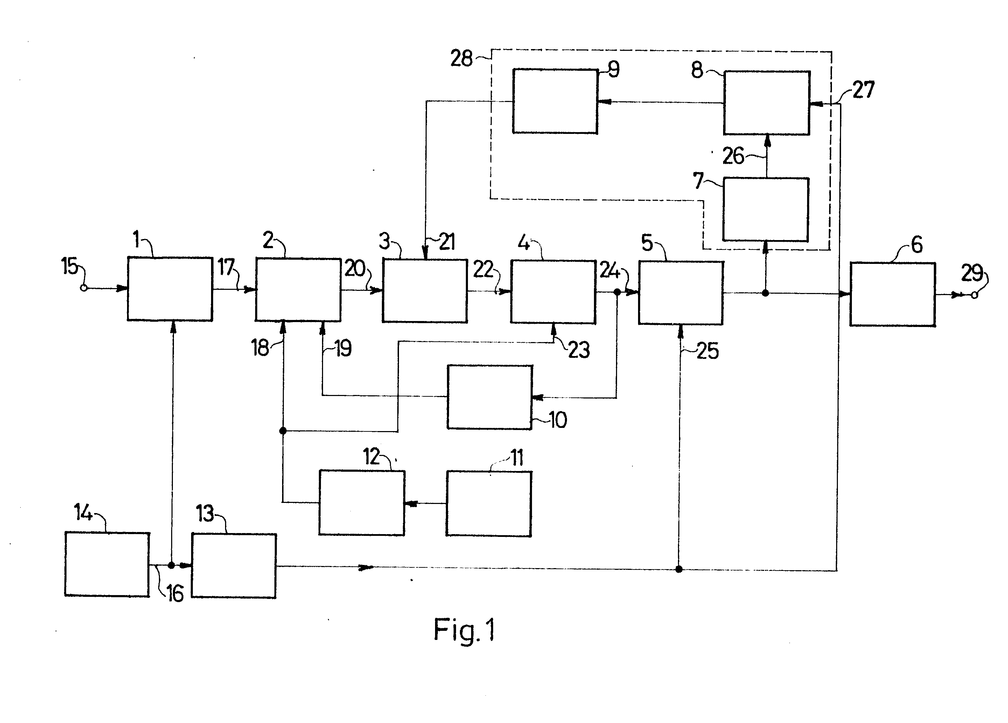

In Fig. 1 kommt das zu messende Hochfrequenzsignal vom Eingang 15 durch eine Kopplungseinheit 1 zum Signaleingang 17 einer Abtasteinheit 2 an. Gleichzeitig mit dem zu messenden Signal ist auch ein Hilfssignal von einer entsprechend gewählten -vorteilhaft ausserhalb des Meßbereichs fallenden, im Vergleich mit der Frequenz der Abtastung niedrigeren -Frequenz am Ausgang 16 eines Hilfsoszillators 14 durch die Kopplungseinheit 1 an den Signaleingang 17 der Abtasteinheit 2 angeschlossen. Die Aufgabe der Kopplungseinheit 1 ist die angepasste Kopplung des zu messenden Spannungssignals und des Hilfssignals an den Signaleingang 17 der Abtasteinheit 2. Der Abtastwert an den Ausgang 20 der Abtasteinheit 2 ist mit der Summe der im Moment der Abtastung aufgenommenen Momentanwerte des zu messenden Signals und des Hilfssignals proportional. Die Öffnung der Abtasteinheit 2 ist durch ihren Steuereingang 18 von einem Generator 12, in der dargestellten Ausführungsform von einem spannungsgesteuerten Oszillator, durchgeführt, die Ausgangsfrequenz dieses letzteren ist von einer Spannungsquelle 11 von veränderlichem Ausgangssignal, z.B. von einem Sägezahngenerator oder Sinusoszillator moduliert.

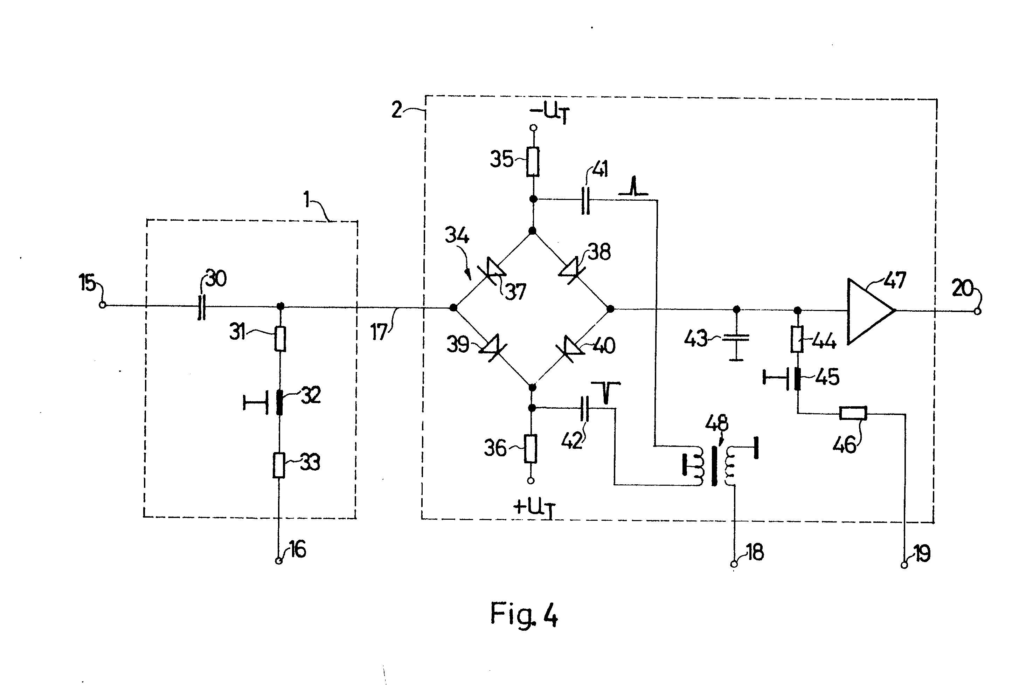

Die Abtasteinheit 2 legt in ihrem eingeschalteten Zustand das zu ihrem Signaleingang 17 kommende Signal an ihren Ausgang 20 und dadurch an den Eingang eines Verstärkers 3 von steuerbarer Verstärkung an. Die in der Abtasteinheit 2 angeordnete Speicherkapazität (siehe Kondensator 43 der Fig. 4) wird auf eine Spannung aufgeladen, die mit einem im Moment der Abtastung aufgenommenen Summenwert des zu messenden Signals und des Hilfssignals proportional ist. Diese Kapazität verliert zwischen zwei Abtastungen ihre Ladung, d.h. der Kondensator 43 entladet sich. Das Ausgangssignal des Verstärkers 3 von steuerbarer Verstärkung schließt sich an den Eingang 22 des Abtast-und Haltestromkreises 4 an. Der Abtast-und Haltestromkreis 4 tastet das von der Abtasteinheit 2 hergestellte und von dem Verstärker 3 verstärkte Signal ab, dadurch führt er nur eine Signalformung (Verstärkung) aus, beeinflußt aber die statistischen Kennwerte des abgetasteten Signals nicht. Der Abtast-und Haltestromkreis 4 soll mit der Abtasteinheit 2 synchrongesteuert werden, undzwar in der Weise, daß er das am Ausgang der Abtasteinheit 2 bzw. dementsprechend am Ausgang des Verstärkers 3 erscheinende Signal bei dem Maximumwert abtasten soll. Dazu ist eine Verzögerung von konstanter Zeitdauer erforderlich. Der Abtast-und Haltestromkreis 4 ist durch seinen Steuereingang 23 von dem entsprechend verzögerten Ausgangssignal des Generators 12 gesteuert. Das Ausgangssignal des Abtast-und Haltestromkreises 4 kommt einerseits durch einen Tiefpassfilter .10, als eine Gleichspannungsrückkopplung an den Rückkopplungseingang 19 der Abtasteinheit 2 an, andererseits schließt sich an einen Eingang 24 des Differenzkreises 5 an. An den anderen Eingang 25 des Differenzkreises 5 - schließt sich durch einen Phasenschieber 13 das Signal des Hilfsoszillators 14 an. Da solange bis das Hilfssignal des Hilfsoszillators 14 vom Eingang der Kopplungseinheit 1 zum Eingang 24 des Differenzkreises 5 ankommt, es eine Phasenverschiebung erleidet, ist die Aufgabe des Phasenschiebers 13 die Gleichphasigkeit der an die Eingänge 24 und 25 des Differenzkreises 5 ankommenden Signale von Frequenz des Hilfsoszillators 14 zu sichern. In dem Falle, wenn die Amplitude und die Phase des an den Eingang 25 des Differenzkreises 5 ankommenden Signals mit der Amplitude und Phase des, an den Eingang 24 ankommenden -zum zu messenden Signal addierten-Signals des Hilfsoszillators 14 übereinstimmen, wird das Differenzsignal von Frequenz des Hilfsoszillators 14, im Vergleich mit dem zu messenden Signal, am Ausgang des Differenzkreises 5 praktisch vernachlässigbar. Falls am Eingang 24 des Differenzkreises 5 nicht ein Signal des Hilfsoszillators 14 von einer, mit der Amplitude des Signals des an den Eingang 25 angeschlossenen Hilfsoszillators 14 übereinstimmenden Amplitude zu finden ist, entsteht, von der Richtung der Abweichung abhängig, am Ausgang des Differenzkreises 5 ein phasenrichtiges (mit dem Signal des Basisoszillators übereinstimmender, oder entgegengesetzter Phase) Differenzsignal von Frequenz des Hilfsoszillators 14.

Der Ausgang des Differenzkreises 5 schließt sich durch einen Verstärker 7 von Tiefpasscharakteristik, z. B. vom Integriertyp, an den Eingang 26 des phasenempfindlichen Gleichrichters 8 an. An den Steuereingang 27 des phasenempfindlichen Gleichrichters 8 ist das Ausgangssignal des Phasenschiebers 13 angeschlossen. Die Aufgabe des Verstärkers 7 vom Integriertyp ist, nach Integrierung des abgetasteten Signals, die Verstärkung des Differenzsignals von Frequenz des Hilfsoszillators 14. Der Ausgang des phasenempfindlichen Gleichrichters 8 schließt sich durch einen Tiefpassfilter 9 an den Steuereingang 21 des Verstärkers 3 von steuerbarer Verstärkung an. Der Verstärker 7, der phasenempfindliche Gleichrichter 8 und der Tiefpassfilter 9 bilden einen Rückkopplungszweig 28. Der phasenempfindliche Gleichrichter 8 stellt mit sehr grosser Selektivität aus dem phasenrichtigen Differenzsignal eine vorzeichenrichtige Steuergleichspannung her, welche - schließlich die Verstärkung des Verstärkers 3 in solchem Grade verändert, daß die, an den Eingängen 24 und 25 des Differenzkreises 5 befindlichen Signale von Frequenz des Hilfsoszillators 14 gleiche Amplituden haben sollen.

Durch die Erhöhung der Verstärkung des Verstärkers 7 vom Integriertyp nimmt das Differenzsignal von Frequenz des Hilfsoszillators 14 am Ausgang des Differenzkreises 5 ab, so kann, im Falle einer entsprechend hoch gewählten Verstärkung, das am Ausgang des Differenzkreises 5 messbare Signal von Frequenz des Hilfsoszillators 14, im Vergleich mit dem zu messenden Signal, immer an einem im voraus bestimmbaren Minimumniveau gehalten werden, es verursacht also bei der Messung keinen Fehler. Diese Ausgestaltung ist deshalb vorteilhaft, weil der Differenzkreis 5 gleichzeitig als Differenzbildungselement der Rückkopplung verwendet werden kann, und der Differenzkreis 5 sich in dem Regelungskreis befindet.

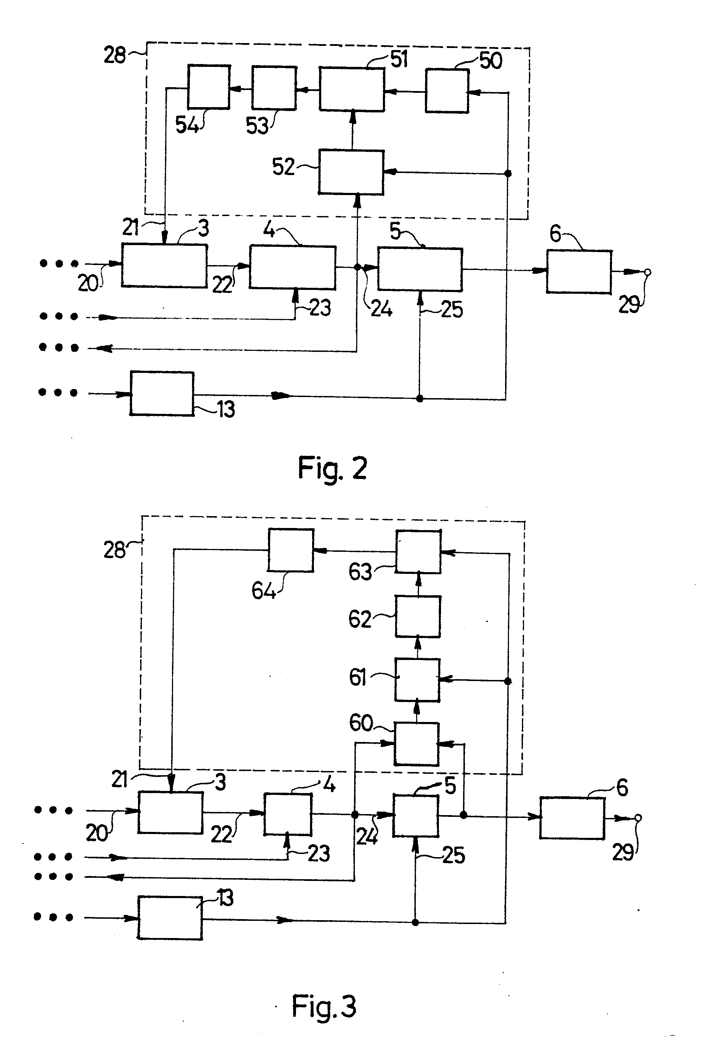

Gemäß Fig. 2 kann der Rückkopplungszweig 28, abweichend von Fig. 1, auch so ausgestaltet werden, daß er zwischen den Eingang 24 des Differenzkreises 5 und den Steuereingang 21 geschaltet ist. In diesem Falle soll in dem Rückkopplungszweig 28 auch eine Differenzbildung durchgeführt werden, da der Differenzkreis 5 in diesem Falle nicht in dem Regelungskreis ist. An den Ausgang des Abtast-und Haltestromkreises 4 - schließt sich unmittelbar ein phasenempfindlicher Gleichrichter 52 an, dessen gefilterter Ausgang zu einem Eingang eines Gleichspannungsdifferenzgliedes 51 ankommt, dessen anderer Eingang von dem gefilterten Signal des, an den Ausgang des Phasenschiebers 13 angeschlossenen Gleichrichters 50 gespeist ist. Der Ausgang des Gleichspannungsdifferenzglieds 51 schließt sich durch einen, die Schleifenverstärkung einstellenden Verstärker 53 und durch einen, zur Stabilität erforderlichen Tiefpassfilter 54 an den Steuereingang 21 an. Bei dieser Ausführung kann das Hilfssignal mit größerer Amplitude für die Rückkopplung erhalten werden, folgenderweise ist das Signal-Rausch-Verhältnis besser.

Gemäß Fig. 3 schließt sich der Rückkopplungszweig 28, abweichend von Fig. 1, sowohl an den Ausgang, als auch an den Eingang 24 des Differenzkreises 5 durch Eingänge eines Differenzglieds 60 an, am dessen Ausgang praktisch nur das, das am Eingang 24 befindliche, zu messende Signal überlagerte Hilfssignal erscheint. Der Ausgang des Differenzglieds 60 kommt an einem Eingang eines die Differenzbildung des Regelungskreises durchführenden Differenzglieds 61 an, dessen anderer Eingang an den Ausgang des Phasenschiebers 14 angeschlossen ist. Das Ausgangssignal des Differenzglieds 61 kommt durch einen Verstärker 62 an den phasenempfindlichen Gleichrichter 63 an, welcher ebenfalls von dem Ausgangssignal des Phasenschiebers 13 gesteuert ist. Das Ausgangssignal des phasenempfindlichen Gleichrichters 63 steuert durch den, zur Stabilität erforderlichen Tiefpassfilter 64 den Steuereingang 21. Der Vorteil dieser Ausführung besteht in dem großen Signal-Rausch-Verhältnis, und darin, daß auch der Differenzkreis 5 sich in dem Regelungskreis befindet.

In der Vorrichtung gemäß der Erfindung ist eine solche Regelungsschleife zu finden, welche dadurch, daß sie für das Hilfssignal des Hilfsoszillators 14 eine temperaturunabhängige Verstärkung gewährleistet, dieselbe auch für das zu messende Signal automatisch sichert.

An den Ausgang des Differenzkreises 5 - schließt sich noch eine Signalverarbeitungseinheit 6 an. In die Signalverarbeitungseinheit 6 kommt eine solche Impulsreihe an, welche nur die statistischen Kennwerte des zu messenden Signals trägt und worin die Wirkung des Signals von Frequenz des Hilfsoszillators 14 vernachlässigbar ist. Die Signalverarbeitungseinheit 6 erzeugt an ihrem Ausgang 29 aus der abgetasteten Impulsreihe ein, mit ihrem Scheitelwert, elektrolytischen Mittelwert und/oder Effektivwert proportionales Signal, und dieses Signal ist mit dem entsprechenden Wert des zu messenden Signals proportional und nach dem entsprechenden Wert des zu messenden Signals kalibriert. Das Signal am Ausgang 29 kann durch einen nicht dargestellten analog-digitalen Wandler zwecks Weiterverarbeitung zu einer Rechenmaschine übermittelt werden. Die Signalverarbeitungseinheit 6 kann ein komplizierterer, einen statistischen Kennwert (z.B. Amplituden verteilung) oder mehrere Kennwerte auch bestimmender Stromkreis sein, und kann sowohl aus analogen, als auch aus digitalen Stromkreisen aufgebaut werden.

Fig. 4 stellt eine solche Ausführung der Kopplungseinheit 1 und der Abtasteinheit 2 gemäß Fig. 1 dar, welche auch für den Zweck eines, in weiterem Frequenzbereich arbeitenden Millivoltmeters geeignet ist. Das zu messende Spannungssignal kommt vom Eingang 15 durch einen Kondensator 30 an den Signaleingang 17 der Abtasteinheit 2 an. Das am Ausgang 16 des Hilfsoszillators 14 befindliche sinusförmige oder rechteckige Hilfssignal von z.B. 1 kHz kommt durch einen Widerstand 33, einen Durchführungskondensator 32 und einen weiteren Widerstand 31 an den Eingang 17 an. Die Kopplungseinheit 1 addiert also die zwei Signale und gleichzeitig sichert mit dem Durchführungskondensator 32, daß das zu messende Hochfrequenzsignal (z. B. 100 kHz -1 GHz) nicht zum Ausgang 16 kommen kann.

Der Eingang 17 schließt sich durch einen analogen Diodenschaltstromkreis 34 an den Eingang eines Verstärkers 47 an, während der Ausgang des Verstärkers 47 den Ausgang 20 der Abtasteinheit 2 bildet. Der Diodenschaltstromkreis 34 enthält vier in Brücken geschaltete Dioden 37, 38, 39 und 40, die durch Widerstände 35 und 36 zwischen Speisespannungen $-U_T$ und $+U_T$ geschaltet sind. Die sich an die Widerstände 35 und 36 anschließenden Punkten der Diodenbrückenschaltung sind durch die Sekundärwicklung eines Impulstransformators 48 mit zueinander synchronen positiven bzw. negativen Impulsen gespeist, entsprechend der an der Primärwicklung durch den Steuereingang 18 vom Generator 12 erhaltenen, z.B. im Bereich von 100 - 150 kHz veränderlichen Steuerung, was die untere Grenzfrequenz des Meßbereichs bestimmt. Der Scheitelwert der positiven und negativen Impulse ist größer als die Speisespannung $U_T$, demgemäß ist der Diodenschaltstromkreis 34 während der Zeitdauer geöffnet, wenn der Momentanwert der Impulse die Speisespannung $U_T$ übertrifft. Diese Zeit dauer ist etwa 0,1 -0,3 ns bei etwa 1 GHz oberen Grenzfrequenz des Meßbereichs.

Zwischen dem Ausgang des Diodenschaltstromkreises 34 und der Erde ist ein, das abgetastete Signal speichernder Kondensator 43 eingeschaltet. An diesen Punkt, welcher auch der Eingang des Verstärkers 47 ist, schließt sich durch einen Widerstand 46, einen Durchführungskondensator 45 und einen weiteren Widerstand 44 der Rückkopplungseingang 19 an, welcher an den Ausgang des Tiefpassfilters 10 angeschlossen ist. Am Eingang des Verstärkers 47 addieren sich also einerseits des abgetastete Summensignal des zu messenden Signals und des Hilfssignals, andererseits das rückgekoppelte Signal, und ein dementsprechendes Signal erscheint am Ausgang des Verstärkers 47, welcher der Ausgang 20 der Abtasteinheit 2 ist.

Die Vorrichtung gemäß der Erfindung ist mit einer entsprechenden Einheit für Strom-Spannung-Umformung auch zur Strommessung geeignet. Diese Einheit ist im einfachsten Falle ein Widerstand, es kann aber z.B. auch einen Stromwandlertransformator enthalten, wenn eine erdunabhängige Messung erforderlich ist. Die Vorrichtung gemäß der Erfindung kann nicht nur zur Einkanal-, sondern auch zur Zweikanalmessung ausgestaltet werden, z.B. der eine Kanal zur Messung der Spannung, der andere aber zur Messung des dazu gehörigen Stromes, und da kann die Signalverarbeitungseinheit 6 ein, mit dem Wert der komplexen Impedanz proportionales Signal erzeugen.

Der wesentliche Vorteil der Erfindung besteht darin, daß keine besondere Wärmestabilität für die Amplitude des Ausgangssignals vom Hilfsoszillator 14 erforderlich ist. Der Differenzkreis 5 bildet die Differenz der aus demselben Hilfsoszillator 14 kommenden Signale, sodaß die Aenderung der Amplitude des Hilfsoszillators 14 keinen Fehler verursacht. Die Wärmestabilität des Systems ist nur von einer Veränderung der Parameter des Phasenschiebers 13, bzw. von einen bedeutenden Veränderung der Frequenz des Hilfsoszillators 14 beeinflußt. Die Wärmestabilität der Parameterwerte des Phasenschiebers 13, ferner die der Frequenz des Hilfsoszillators 14 kann durch eine entsprechende Auswahl des Types der verwendeten passiven R, L, C Elemente leicht gesichert werden.

Ein weiterer Vorteil der Erfindung besteht darin, daß sie, über die temperaturabhängigen Veränderungen der Verstärkung hinaus, auch die infolge der Alterung der Bestandteile auftretenden Veränderungen zu kompensieren fähig ist.

Der wirtschaftliche Vorteil der Lösung besteht darin, daß eine bedeutende Verbesserung der Spezifikation mit einem Niederfrequenzelementensatz erreicht ist, dessen Preis neben dem Materialpreis der kompletten Vorrichtung vernachlässigbar ist, ferner welcher den Einbau einer Eichungseinheit in die Vorrichtung, oder die Anwendung eines in Funktion der Temperatur veränderlichen, kostspieligen Korrektionsverstärkers in der Signalverarbeitungseinheit 6 unnötig macht.

Die Vorrichtung gemäß der Erfindung entspricht in jeder Hinsicht den, bei den in den Meßautomaten anwendbaren, analoge Parameter messenden, programmierbaren Vorrichtungen erhobenen spezialen Ansprüchen. Im Falle ihrer Verwendung als Einzelvorrichtung im Laboratorium verfügt sie über bessere technische Angaben als die, in dieser Kategorie vorhandenen ähnlichen Vorrichtungen.

**Ansprüche**

1. Vorrichtung zur Spannungsmessung durch Abtastung, enthaltend eine die zu messende Spannung abtastende Einheit, einen das abgetastete Signal verstärkenden Verstärker und eine das verstärkte Signal der vorgeschriebenen Messaufgabe entsprechend auswertende Signalverarbeitungseinheit, wobei die Abtasteinheit an einen Steuergenerator angeschlossen ist, dadurch **gekennzeichnet,** daß sie einen, ein Hilfssignal herstellenden Hilfsoszillator (14), sowie zwischen der Abtasteinheit (2) und der Signalverarbeitungseinheit (6) einen Verstärker (3) von steuerbarer Verstärkung und einen Differenzkreis (5) aufweist, daß das Hilfssignal einerseits, mit der zu messenden Spannung zusammen, an einen Signaleingang (17) der Abtasteinheit (2), andererseits durch einen Phasenschieber (13) an einen Eingang (25) des Differenzkreises (5) angeschlossen ist, und daß zwischen einerseits den Ausgang des Differenzkreises (5) und/oder seinen dem steuerbaren Verstärker (3) angeschlossenen anderen Eingang (24), andererseits den Steuereingang (21) des steuerbaren Verstärkers (3) ein auf die Frequenz des Hilfssignals selektiver Rückkopplungszweig (28) angeschlossen ist.

2. Vorrichtung nach Anspruch 1, dadurch **gekennzeichnet,** daß der dem Ausgang des Differenzkreises (5) angeschlossene Rückkopplungszweig (28) einen weiteren Verstärker (7), einen durch Ausgangssignal des Phasenschiebers (13) gesteuerten phasenempfindlichen Gleichrichter (8) und einen ersten Tiefpassfilter (9) enthält, die in Reihe geschaltet sind.

3. Vorrichtung nach Anspruch 2, dadurch **gekennzeichnet,** daß der weitere Verstärker (7) eine Tiefpasscharakteristik aufweist.

4. Vorrichtung nach Anspruch 1, dadurch **gekennzeichnet,** daß der dem erwähnten anderen Eingang (24) des Differenzkreises (5) angeschlossene Rückkopplungszweig (28) einen phasenempfindlichen Gleichrichter (52), ein Gleichspannungsdifferenzglied (51), einen weiteren Verstärker (53) und einen ersten Tiefpassfilter (54) enthält, die in Reihe geschaltet sind, wobei ein Eingang des Gleichspannungsdifferenzglieds (51) durch Zwischenschaltung eines Gleichrichters (50) an den Phasenschieber (13) angeschlossen ist.

5. Vorrichtung nach Anspruch 1, dadurch **gekennzeichnet,** dass der dem Ausgang und dem erwähnten anderen Eingang (24) des Differenzkreises (5) angeschlossene Rückkopplungszweig (28) ein, sich mit seinen zwei Eingängen an den Ausgang und an den erwähnten anderen Eingang (24) des Differenzkreises (5) anschließendes erstes Differenzglied (60), ein zweites Differenzglied (61), einen weiteren Verstärker (62), einen phasenempfindlichen Gleichrichter (63) und einen ersten Tiefpassfilter (64) enthält, die in Reihe geschaltet sind, wobei ein Eingang des zweiten Differenzglieds - (61) und der Steuereingang des phasenempfindlichen Gleichrichters (63) an den Phasenschieber - (13) angeschlossen sind.

6. Vorrichtung nach einem der Ansprüche 1 bis 5, dadurch **gekennzeichnet,** daß der erwähnte andere Eingang des Differenzkreises (5) durch Zwischenschaltung eines, im Verhältnis zur Abtasteinheit (2) ver zögert gesteuerten Abtast-und Haltestromkreises (4) an den Ausgang des steuerbaren Verstärkers (3) angeschlossen ist.

7. Vorrichtung nach Anspruch 6, dadurch **gekennzeichnet,** daß der Ausgang des Abtast-und Haltestromkreises (4) durch einen zweiten Tiefpassfilter (10) an einen Rückkopplungseingang - (19) der Abtasteinheit (2) angeschlossen ist.

8. Vorrichtung nach einem der Ansprüche 1 bis 7, dadurch **gekennzeichnet,** dass der, die Abtasteinheit (2) steuernde Generator (12) ein spannungsgesteuerter Oszillator ist, dessen Steuereingang an eine Spannungsquelle (11) vom veränderlichen Ausgangssignal angeschlossen ist.

9. Vorrichtung nach einem der Ansprüche 1 bis 8, dadurch **gekennzeichnet,** daß die Frequenz des Hilfsoszillators (14) kleiner als die untere Grenze des Frequenzbereichs der zu messenden Spannung ist.

10. Vorrichtung nach einem der Ansprüche 1 bis 9, dadurch **gekennzeichnet,** daß die Abtasteinheit (2) einen analogen Diodenschaltstromkreis (34) enthält, dessen Signaleingang (17) einerseits durch einen Kondensator (30) an den, die zu messende Spannung annehmenden Eingang (15), andererseits durch in Reihe geschaltete Widerstände (31, 33) und einen Durchführungskondensator (32) an den Ausgang (16) des Hilfsoszillators (14) angeschlossen ist.

11. Vorrichtung nach einem der Ansprüche 1 bis 10, dadurch **gekennzeichnet,** daß die Signalverarbeitungseinheit (6) ein, den Effektivwert, den Scheitelwert und/oder den elektrolytischen Mittelwert messender Stromkreis ist.

12. Vorrichtung nach einem der Ansprüche 1 bis 10, dadurch **gekennzeichnet,** daß die Signalverarbeitungseinheit (6) eine, mindestens einen statistischen Kennwert des zu ihrem Eingang ankommenden Signals bestimmende analoge oder digitale Einheit ist.

Fig.1

0 227 908

## Fig. 2

## Fig. 3

Fig. 4

**Europäisches Patentamt**

**EUROPÄISCHER RECHERCHENBERICHT**

Nummer der Anmeldung

EP 86 11 4868

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-3 412 331 (HEWLETT-PACKARD) * Spalte 1, Zeile 19 - Spalte 2, Zeile 17; Figur 1 * | 1 | G 01 R 19/00 G 01 R 13/34 |
| A | DE-B-1 293 249 (T. HOUSTON-HOTCHKISS BRANDT) * Spalte 1, Zeile 51 - Spalte 5, Zeile 47; Figuren 1,2 * | 1 | |
| A | DE-A-1 949 056 (VEB FUNKWERK) * Seite 4, Zeilen 8-34; Figur 1 * | 1 | |
| A | US-A-3 896 389 (BASSE) * Spalte 1, Zeile 50 - Spalte 2, Zeile 13; Spalte 2, Zeile 24 - Spalte 3, Zeile 67; Figuren 1a,1b * | 1 | |
| A | GB-A-2 078 980 (MARCONI) * Seite 1, Spalte 2, Zeile 97 - Seite 2, Spalte 1, Zeile 35; Figur 1 * | 1 | RECHERCHIERTE SACHGEBIETE (Int. Cl.4) G 01 R 13/00 G 01 R 19/00 G 01 R 29/00 |

Der vorliegende Recherchenbericht wurde für alle Patentansprüche erstellt.

| Recherchenort | Abschlußdatum der Recherche | Prüfer |
|---|---|---|
| DEN HAAG | 06-03-1987 | TRELEVEN C. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82